# EUROPEAN PATENT SPECIFICATION

(11) **EP 3 496 156 B1**
(45) Date of publication and mention of the grant of the patent: **15.09.2021**
(21) Application number: 18183100.9
(22) Date of filing: 12.07.2018
(51) Int. Cl.: H01L 31/0224, H01L 31/0236, H01L 31/068, H01B 1/22

(54) **SOLAR CELL**
SOLARZELLE
CELLULE SOLAIRE

(30) Priority: 08.12.2017 KR 20170168655
(43) Date of publication of application: 12.06.2019
(73) Proprietor: Changzhou Fusion New Material Co. Ltd., Jiangsu Province (CN)
(72) Inventor: PARK, Sang Hee, Suwon-si, Gyeonggi-do 16678 (KR); KIM, Sang Jin, Suwon-si, Gyeonggi-do 16678 (KR); CHO, Jae Hwi, Suwon-si, Gyeonggi-do 16678 (KR); HA, Hyun Jin, Suwon-si, Gyeonggi-do 16678 (KR)
(74) Representative: Michalski Hüttermann & Partner Patentanwälte mbB

(56) References cited:
- EP-A1- 2 980 857
- EP-A1- 3 306 674
- WO-A1-2016/190422
- MOHAMED M. HILALI ET AL: "Effect of glass frit chemistry on the physical and electrical properties of thick-film Ag contacts for silicon solar cells", JOURNAL OF ELECTRONIC MATERIALS., vol. 35, no. 11, 1 November 2006 (2006-11-01), pages 2041-2047, XP055535005, US ISSN: 0361-5235, DOI: 10.1007/s11664-006-0311-x
- YUPING TAI ET AL: "Effect of glass frit in Ag paste on the electrical properties of front-side Ag contacts for crystalline-silicon solar cells", RSC ADVANCES, vol. 5, no. 112, 1 January 2015 (2015-01-01), pages 92515-92521, XP055535009, DOI: 10.1039/C5RA11282F

## Description

### Field of the Invention

The present invention relates to a solar cell.

### Description of Related Art

Solar cells generate electricity using the photovoltaic effect of a PN junction which converts photons of sunlight into electricity. In a solar cell, front and rear electrodes are formed on upper and lower surfaces of a semiconductor wafer or substrate having a PN junction, respectively. Then, the photovoltaic effect at the PN junction is induced by sunlight entering the semiconductor wafer and electrons generated by the photovoltaic effect at the PN junction provide electric current to the outside through the electrodes. The electrodes of the solar cell are formed on the wafer by applying, patterning, and baking a composition for solar cell electrodes.

In order to reduce reflectance of light incident on a solar cell to improve efficiency of the solar cell, there has been proposed a method in which a surface of a substrate is textured and/or is formed with an anti-reflection film. However, this method cannot provide sufficient anti-reflection properties.

In addition, the method has a problem in that an electrode can have poor adhesion to the substrate having a textured surface.

Therefore, there is a need for a solar cell which can reduce reflection of light incident thereon and improve adhesion of an electrode to a substrate, thereby exhibiting good electrical properties, such as contact resistance, serial resistance, short-circuit current and conversion efficiency.

The background technique of the present invention is disclosed in Japanese Unexamined Patent Publication No. 2012-084585.

EP 2 980 857 A1 discloses a conductive paste for forming a solar cell element front surface electrode that has a lower contact resistance and a high tensile strength; and a method for manufacturing the same. A conductive paste for a solar cell element front surface electrode that is used to form a front surface electrode of a solar cell element that is provided with a semiconductor substrate, an antireflective film disposed in a first region on one main surface of the semiconductor substrate, and a front surface electrode disposed in a second region on the one main surface of the semiconductor substrate. The conductive paste is characterized by comprising a conductive powder, a mixed glass frit, and an organic vehicle in which the mixed glass frit contains, in the form of mixture, a tellurium-based glass frit containing tellurium, tungsten, and bismuth as essential components and a lead-bismuth-based glass frit that contains lead and bismuth as essential components and that substantially does not contain tellurium

WO 2016/190422 A1 discloses a solar cell element which includes a semiconductor substrate including a p-type semiconductor region at one surface, a passivation layer located on the p-type semiconductor region and containing aluminum oxide, and a protective layer located on the passivation layer and including polysiloxane which contains an alkyl group.

### Summary of the Invention

It is one aspect of the present invention to provide a solar cell which can reduce reflectance, thereby exhibiting improved conversion efficiency.

It is another aspect of the present invention to provide a solar cell which can improve adhesion of an electrode to a substrate, thereby exhibiting good electrical properties, such as contact resistance, serial resistance and short-circuit current.

These and other objects of the present invention can be achieved by embodiments of the present invention described below.

An aspect of the present invention relates to a solar cell.

The solar cell includes: a silicon substrate; and an electrode formed on the silicon substrate, wherein the silicon substrate is formed with at least 5 raised portions having a cross-sectional height (h) of 50 nm or more per 5 µm length, and the electrode is formed of a composition for solar cell electrodes including a conductive powder, an organic vehicle, and a glass frit having a glass transition temperature (Tg) of 150°C to 450°C.

The glass frit may have a crystallization temperature (Tc) of 300°C to 650°C.

The glass frit may have a melting point (Tm) of 350°C to 700°C.

The glass frit may be formed of a metal oxide, wherein the metal oxide may include at least one elemental metal selected from among tellurium (Te), lithium (Li), zinc (Zn), bismuth (Bi), lead (Pb), sodium (Na), phosphorus (P), germanium (Ge), gallium (Ga), cerium (Ce), iron (Fe), silicon (Si), tungsten (W), magnesium (Mg), molybdenum (Mo), cesium (Cs), strontium (Sr), titanium (Ti), tin (Sn), indium (In), vanadium (V), barium (Ba), nickel (Ni), copper (Cu), potassium (K), arsenic (As), cobalt (Co), zirconium (Zr), manganese (Mn), aluminum (Al), and boron (B).

The glass frit may include at least one selected from among Bi-Te-O glass frits, Pb-Bi-O glass frits, Pb-Te-O glass frits, Te-B-O glass frits, Te-Ag-O glass frits, Pb-Si-O glass frits, Bi-Si-O glass frits, Te-Zn-O glass frits, Bi-B-O glass frits, Pb-B-O glass frits, Bi-MoO glass frits, Mo-B-O glass frits, and Te-Si-O glass frits.

The glass frit may have an average particle diameter of 0.1 µm to 10 µm.

The composition for solar cell electrodes may include: 60 wt% to 95 wt% of the conductive powder; 0.1 wt% to 20 wt% of the glass frit; and 1 wt% to 30 wt% of the organic vehicle.

The composition for solar cell electrodes may further include at least one additive selected from among a dispersant, a thixotropic agent, a plasticizer, a viscosity stabilizer, an anti-foaming agent, a pigment, a UV stabilizer, an antioxidant, and a coupling agent.

The present invention provides a solar cell which can reduce reflectance, thereby exhibiting improved conversion efficiency and can improve adhesion of an electrode to a substrate, thereby exhibiting good electrical properties, such as contact resistance, serial resistance and short-circuit current.

### Brief Description of Drawings

FIG. 1 is a schematic view of a solar cell according to one embodiment of the present invention.
Fig. 2 is a view illustrating the definition of a raised portion according to the present invention.
FIG. 3 is an electron microscope image showing a raised portion of a solar cell according to the present invention.
FIG. 4 is an electron microscope image of Comparative Example 3 (a surface of a typical substrate).

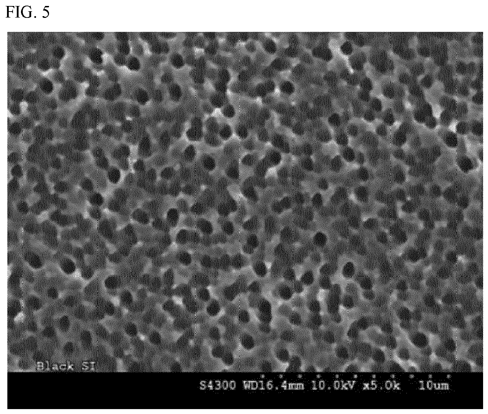

FIG. 5 is an electron microscope image of a surface of a substrate according to Example of the present invention.

### Detailed Description of the Invention

Hereinafter, embodiments of the present invention will be described in detail.

Description of known functions and constructions which may unnecessarily obscure the subject matter of the present invention will be omitted.

As used herein, the singular forms, "a," "an," and "the" are intended to include the plural forms as well, unless context clearly indicates otherwise. Moreover, the terms "comprises," "comprising," "includes," and/or "including," when used in this specification, specify the presence of stated features, integers, steps, operations, elements, components, and/or groups thereof, but do not preclude the presence or addition of one or more other features, integers, steps, operations, elements, components, and/or groups thereof.

In addition, unless stated otherwise, a margin of error is considered in analysis of components.

As used herein, the term "metal oxide" may refer to one metal oxide or a plurality of metal oxides.

Further, "X to Y", as used herein to represent a range of a certain value means "greater than or equal to X and less than or equal to Y".

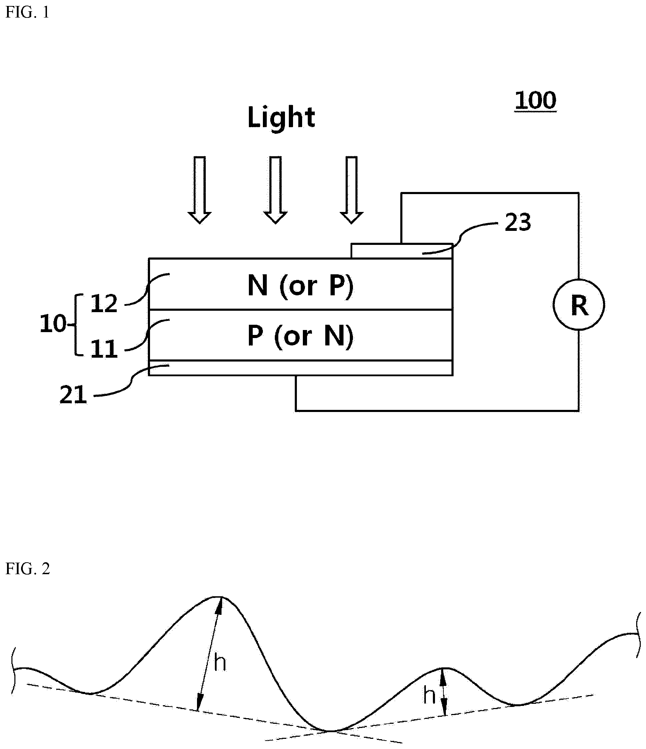

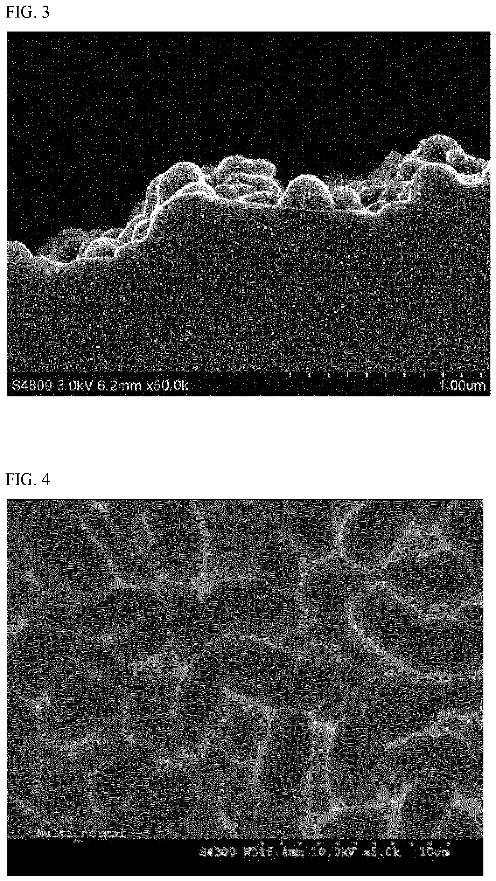

As used herein, the phrase "a substrate has a raised portion having a height (h) of 50 nm or more" means that the portion is higher than the surrounding surface and has a diameter of 500 nm or less, and a vertical distance from the summit of the portion to a line connecting both sides of the portion is 50 nm or more in sectional view of the silicon substrate (see FIG. 2). FIG. 3 is an actual sectional image of a silicon substrate for defining a raised portion according to the present invention.

### Solar cell

A solar cell according to one embodiment of the present invention will be described with reference to FIG. 1. FIG. 1 is a schematic view of a solar cell according to one embodiment of the present invention.

The solar cell 100 according to this embodiment may include a silicon substrate 10 and an electrode formed on the silicon substrate 10. Specifically, the solar cell may include a front electrode 23 formed on a front surface of the silicon substrate 10. The silicon substrate 10 may be a substrate with a PN junction formed thereon, and a rear electrode 21 may be formed on a back surface of the silicon substrate 10. Specifically, the silicon substrate 10 may include a semiconductor substrate 11 and an emitter 12. More specifically, the silicon substrate 10 may be a substrate prepared by doping one surface of a p-type semiconductor substrate 11 with an n-type dopant to form an n-type emitter 12. Alternatively, the substrate 10 may be a substrate prepared by doping one surface of an n-type semiconductor substrate 11 with a p-type dopant to form a p-type emitter 12. Here, the semiconductor substrate 11 may be either a p-type substrate or an n-type substrate. The p-type substrate may be a semiconductor substrate 11 doped with a p-type dopant, and the n-type substrate may be a semiconductor substrate 11 doped with an n-type dopant.

In description of the silicon substrate 10, the semiconductor substrate 11 and the like, a surface of such a substrate through which light enters the substrate is referred to as a front surface (light receiving surface). In addition, a surface of the substrate opposite the front surface is referred to as a back surface.

In one embodiment, the semiconductor substrate 11 may be formed of crystalline silicon or a compound semiconductor. Here, the crystalline silicon may be monocrystalline or polycrystalline. As the crystalline silicon, for example, a silicon wafer may be used.

Here, the p-type dopant may be a material including a group III element such as boron, aluminum, or gallium. In addition, the n-type dopant may be a material including a group V element, such as phosphorus, arsenic or antimony.

The rear electrode 21 and/or the front electrode 23 may be fabricated using a composition for solar cell electrodes described below. Specifically, the rear electrode and/or the front electrode may be fabricated through a process in which the composition for solar cell electrodes is deposited on the substrate by printing, followed by baking.

The solar cell 100 according to this embodiment includes the silicon substrate 10 and the electrode formed on the substrate 10, wherein the silicon substrate may be formed with 5 or more, specifically 5 to 100, more specifically 5 to 50 raised portions having a height (h) of 50 nm or more per 5 µm length in sectional view.

The silicon substrate having 5 or more raised portions can have higher surface roughness than a typical Si wafer, thereby further reducing reflectance of sunlight and can have an increased contact area with the electrode, thereby providing good properties in terms of contact resistance (Rc) and short-circuit current (Isc).

There are two primary methods to form a nano-texture (or raised portions) on the silicon substrate: wet etching and dry etching. A representative example of wet etching is metal catalyzed chemical etching (MCCE). For example, saw damage caused by diamond sawing is removed through a saw damage removal (SDR) process, followed by formation of a nano-texture through MCCE. Herein, "MCCE" refers to a process of gradually etching a surface of a Si substrate with silver nitrate (AgNO₃), followed by removal of silver nanoparticles, i.e., byproducts. A representative example of dry etching is reactive ion etching (RIE) in which a silicon wafer subjected to SDR is dry-etched using plasma. Here, SF₆/O₂ gas is used to generate plasma and a SiOF layer used as a mask needs to be removed.

In the present invention, a nano-texture (or the number of raised portions) of the silicon substrate is controlled by wet etching.

In another embodiment, the solar cell according of the present invention may further include an anti-reflection film (not shown) on the front surface of the silicon substrate 10. In addition, a back surface field layer (not shown), an anti-reflection film (not shown), and the rear electrode 21 may be sequentially formed on the back surface of the silicon substrate 10. Here, the front electrode 23 or the rear electrode 21 may be formed in a bus bar pattern.

Hereinafter, for convenience of explanation, each component of the solar cell according to the present invention will be described on the assumption that the semiconductor substrate 11 is a p-type substrate. However, it should be understood that the present invention is not limited thereto and the semiconductor substrate 11 may be an n-type substrate.

One surface of the p-type substrate 11 is doped with an n-type dopant to form an n-type emitter 12 to establish a PN junction. Here, the PN junction may be established at an interface between the semiconductor substrate and the emitter. Electrons generated in the PN junction may be collected by the front electrode 23.

The substrate 10 may have a textured structure on the front surface thereof. The textured structure may be formed by surface treatment of the front surface of the substrate 10 using a typical method known in the art, such as etching. The textured structure serves to condense light entering the front surface of the substrate. The textured structure may have a pyramidal shape, a square honeycomb shape, a triangular honeycomb shape, and the like. Thus, the textured structure allows an increased amount of light to reach the PN junction and reduces reflectance of light, thereby minimizing optical loss.

According to the present invention, the silicon substrate having the textured structure may further include raised portions, thereby further reducing reflectance of sunlight while providing further improved properties in terms of contact resistance (Rc) and short-circuit current (Isc).

The p-type substrate may be formed on the back surface thereof with the back surface field (BSF) layer capable of inducing back surface field (BSF) effects.

The back surface field layer is formed by doping the back surface of the p-type semiconductor substrate 11 with a high concentration of p-type dopant. The back surface field layer has a higher doping concentration than the p-type semiconductor substrate 11, which results in a potential difference between the back surface field layer and the p-type semiconductor substrate 11. This makes it difficult for electrons generated in the p-type semiconductor substrate 11 to shift towards the back surface of the substrate so as to prevent recombination with metals, thereby reducing electron loss. As a result, both open circuit voltage (Voc) and fill factor can be increased, thereby improving solar cell efficiency.

In addition, a first anti-reflection film (not shown) and/or a second anti-reflection film 50 may be formed on an upper surface of the n-type emitter 12 and on a lower surface of the back surface field layer, respectively.

The first and second anti-reflection films can reduce reflectance of light while increasing absorption of light at a specific wavelength. In addition, the first and second anti-reflection films can enhance contact efficiency with silicon present on the surface of the silicon substrate 10, thereby improving solar cell efficiency. Accordingly, the first and second anti-reflection films may include a material that reflects less light and exhibits electric insulation. Further, the first and second anti-reflection films may have an uneven surface, or may have the same form as that of the textured structure formed on the substrate. In this case, return loss of incident light can be reduced.

The first and second anti-reflection films may include at least one of, for example, oxides including aluminum oxide (Al₂O₃), silicon oxide (SiO₂), titanium oxide (TiO₂ or TiO₄), magnesium oxide (MgO), cerium oxide (CeO₂), or combinations thereof; nitrides including aluminum nitride (AlN), silicon nitride (SiNx), titanium nitride (TiN), or combinations thereof; and oxynitrides including aluminum oxynitride (AlON), silicon oxynitride (SiON), titanium oxynitride (TiON), or combinations thereof. In this case, the first and second anti-reflection films can exhibit further improved anti-reflection efficiency.

The anti-reflection films may be formed by, for example, atomic layer deposition (ALD), vacuum deposition, atmospheric pressure chemical vapor deposition, plasma enhanced chemical vapor deposition, and the like.

In one embodiment, the anti-reflection films may be formed of silicon nitride (SiNₓ) or the like by plasma enhanced chemical vapor deposition (PECVD). By way of another example, the anti-reflection films may be formed of aluminum oxide (Al₂O₃) or the like by atomic layer deposition (ALD).

In one embodiment, the first anti-reflection film may be formed on the front surface of the silicon substrate 10 and may have a monolayer or multilayer structure.

When the back surface of the p-type semiconductor substrate 11 is doped with boron to form the back surface field layer, the second anti-reflection film (not shown) may be formed on a lower surface of the back surface field layer. The second anti-reflection film can further increase open circuit voltage.

After formation of the anti-reflection films, the front electrode 23 electrically connected to the n-type emitter layer 12 and the rear electrode 21 electrically connected to the p-type substrate 11 may be formed. The front electrode 23 allows electrons collected by the n-type emitter to shift thereto. The rear electrode 21 electrically communicates with the p-type substrate and serves as a path through which electric current flows.

In this embodiment, the front electrode 23 and the rear electrode 21 may be formed of the composition for solar cell electrodes.

For example, the composition for solar cell electrodes may be deposited on the back surface of the PN junction substrate by printing. Then, a preliminary process of preparing the rear electrode is performed by drying at about 200°C to about 400°C for about 10 to 60 seconds. Further, a preliminary process for preparing the front electrode may be performed by printing the composition for solar cell electrodes on the front surface of the PN junction substrate, followed by drying the printed composition. Then, the front electrode and the rear electrode may be formed by baking at about 400°C to about 950°C, for example, at about 750°C to about 950°C, for about 30 to 180 seconds.

When the front electrode or the rear electrode according to this embodiment of the present invention is formed of the composition for solar cell electrodes described below, the silicon substrate can exhibit good adhesion to the electrodes despite having the raised portions, thereby providing further improved properties in terms of contact resistance, serial resistance and the like.

### Composition for solar cell electrodes

The composition for solar cell electrodes according to the present invention includes a conductive powder, an organic vehicle, and a glass frit having a glass transition temperature (Tg) of ≥ 150°C to ≤ 450°C.

Now, each component of the composition for solar cell electrodes according to the present invention will be described in more detail.

### Conductive powder

The composition for solar cell electrodes according to the present invention may include silver (Ag) powder as the conductive powder. The silver powder may have a nanometer or micrometer-scale particle size. For example, the silver powder may have an average particle diameter of dozens to several hundred nanometers, or an average particle diameter of several to dozens of micrometers. Alternatively, the silver powder may be a mixture of two or more types of silver powder having different particle sizes.

The silver powder may have, for example, a spherical, flake or amorphous particle shape.

The average particle diameter may be measured using, for example, a Model 1064D (CILAS Co., Ltd.) after dispersing the conductive powder in isopropyl alcohol (IPA) at 25°C for 3 minutes via ultrasonication. The conductive powder may be present in an amount of about 60 wt% to about 95 wt% based on the total weight of the composition for solar cell electrodes. Within this range, the composition can reduce resistance of a solar cell electrode, thereby improving conversion efficiency of a solar cell. In addition, the composition can be easily prepared in paste form. Specifically, the silver powder may be present in an amount of ≥ 60 wt% to ≤ 95 wt%, specifically ≥ 65 wt% to ≤ 95 wt%, more specifically ≥ 65 wt% to ≤ 90 wt% based on the total weight of the composition for solar cell electrodes. Within this range, the composition can improve conversion efficiency of a solar cell and can be easily prepared in paste form.

### Glass frit

The glass frit serves to form silver crystal grains in an emitter region by etching an anti-reflection layer and melting the conductive powder during a baking process of the composition for solar cell electrodes. Further, the glass frit improves adhesion of the conductive powder to a wafer and is softened to decrease the baking temperature during the baking process.

The glass frit may have a glass transition temperature (Tg) of ≥ 150°C to ≤ 450°C, specifically, ≥ 180°C to ≤ 400°C, more specifically, ≥ 200°C to ≤ 350°C. Within this range, the composition can be well deposited on a silicon substrate having raised portions and can have good adhesion to the substrate, thereby further improving electrical properties such as contact resistance and serial resistance. If the glass transition temperature (Tg) of the glass frit is less than 150°C, the composition spreads and is thus difficult to form into an electrode, whereas, if the glass transition temperature (Tg) of the glass frit exceeds 450°C, the composition cannot sufficiently permeate a space between the raised portions and thus has low adhesion to the substrate and thus poor electrical properties.

The glass frit may have a crystallization temperature (Tc) of ≥ 300°C to ≤ 650°C, specifically ≥ 300°C to ≤ 600°C, more specifically, ≥ 400°C to ≤ 550°C. In addition, the glass frit may have a melting point (Tm) of ≥ 350°C to ≤ 700°C, specifically ≥ 350°C to ≤ 650°C, more specifically, ≥ 400°C to ≤ 600°C. When the crystallization temperature (Tc) and the melting point (Tm) of the glass frit fall within these ranges, an electrode formed of the composition can have further improved adhesion to the silicon substrate.

The glass frit may include at least one of tellurium (Te), lithium (Li), zinc (Zn), bismuth (Bi), lead (Pb), sodium (Na), phosphorus (P), germanium (Ge), gallium (Ga), cerium (Ce), iron (Fe), silicon (Si), tungsten (W), magnesium (Mg), molybdenum (Mo), cesium (Cs), strontium (Sr), titanium (Ti), tin (Sn), indium (In), vanadium (V), barium (Ba), nickel (Ni), copper (Cu), potassium (K), arsenic (As), cobalt (Co), zirconium (Zr), manganese (Mn), aluminum (Al), and boron (B). The glass frit may be formed of an oxide of the at least one elemental metal.

For example, the glass frit may include at least one selected from among Bi-Te-O glass frits, Pb-Bi-O glass frits, Pb-Te-O glass frits, Te-B-O glass frits, Te-Ag-O glass frits, Pb-Si-O glass frits, Bi-Si-O glass frits, Te-Zn-O glass frits, Bi-B-O glass frits, Pb-B-O glass frits, Bi-Mo-O glass frits, Mo-B-O glass frits, and Te-Si-O glass frits. In this case, a solar cell electrode formed of the composition can exhibit good balance between electrical properties.

The glass frit may be prepared by any suitable method known in the art. For example, the glass frit may be prepared by mixing the aforementioned components using a ball mill or a planetary mill, melting the mixture at 900°C to 1300°C, and quenching the melted mixture to 25°C, followed by pulverizing the obtained product using a disk mill, a planetary mill or the like. The glass frit may have an average particle diameter (D50) of ≥ 0.1 µm to ≤ 10 µm, specifically, ≥ 0.1 µm to ≤ 7 µm, more specifically, ≥ 0.1 µm to ≤ 5 µm.

In the present specification D50 means that at least 50% percent of the particles have a diameter of 0.1 µm to 10 µm.

The glass frit may be present in an amount of ≥ 0.1 wt% to ≤ 20 wt%, specifically ≥ 0.5 wt% to ≤ 10 wt%, more specifically ≥ 0.5 wt% to ≤ 7 wt% based on the total weight of the composition for solar cell electrodes. Within this range, the glass frit can secure stability of a PN junction under various sheet resistances, minimize resistance, and ultimately improve the efficiency of a solar cell.

### Organic vehicle

The organic vehicle imparts suitable viscosity and rheological characteristics for printing to the composition for solar cell electrodes through mechanical mixing with inorganic components of the composition.

The organic vehicle may be any typical organic vehicle used in a composition for solar cell electrodes and may generally include a binder resin, a solvent, and the like.

The binder resin may be acrylate resins or cellulose resins. Ethyl cellulose is generally used as the binder resin. In addition, the binder resin may be ethyl hydroxyethyl cellulose, nitrocellulose, blends of ethyl cellulose and phenol resins, alkyd resins, phenol resins, acrylate ester resins, xylene resins, polybutane resins, polyester resins, urea resins, melamine resins, vinyl acetate resins, wood rosin, polymethacrylates of alcohols, and the like.

The solvent may include at least one of, for example, hexane, toluene, ethyl cellosolve, cyclohexanone, butyl cellosolve, butyl carbitol (diethylene glycol monobutyl ether), dibutyl carbitol (diethylene glycol dibutyl ether), butyl carbitol acetate (diethylene glycol monobutyl ether acetate), propylene glycol monomethyl ether, hexylene glycol, terpineol, methylethylketone, benzyl alcohol, γ-butyrolactone, ethyl lactate, and mixtures thereof.

The organic vehicle may be present in an amount of ≥ 1 wt% to ≤ 30 wt%, specifically ≥ 1 wt% to ≤ 25 wt%, more specifically ≥ 1 wt% to ≤ 10 wt% in the composition for solar cell electrodes. Within this range, the organic vehicle can provide sufficient adhesive strength and good printability to the composition.

### Additive

The composition for solar cell electrodes according to the present invention may further include any typical additive to enhance flowability, processability and stability, as needed. The additive may include a dispersant, a thixotropic agent, a plasticizer, a viscosity stabilizer, an anti-foaming agent, a pigment, a UV stabilizer, an antioxidant, a coupling agent, and the like. These may be used alone or as a mixture thereof. The additive may be present in an amount of 0.1 wt% to 5 wt% based on the total weight of the composition for solar cell electrodes, although the content of the additive may be changed, as needed.

Next, the present invention will be described in more detail with reference to examples. However, it should be noted that these examples are provided for illustration only and should not be construed in any way as limiting the invention.

In addition, description of details apparent to those skilled in the art will be omitted for clarity.

### Example 1

As an organic binder, 1.6 wt% of ethylcellulose (STD4, Dow Chemical Company) was sufficiently dissolved in 5.1 wt% of butyl carbitol at 60°C, and then 88.9 wt% of spherical silver powder (AG-4-8, Dowa Hightech Co., Ltd.) having an average particle diameter of 2.0 µm, 3.1 wt% of a Pb-Te-O glass frit having an average particle diameter of 1.0 µm (Tg: 275°C, Tc: 410°C, Tm: 530°C), 0.5 wt% of a dispersant (BYK102, BYK-chemie), and 0.8 wt% of a thixotropic agent (Thixatrol ST, Elementis Co., Ltd.) were added to the binder solution, followed by mixing and kneading in a 3-roll kneader, thereby preparing a composition for solar cell electrodes.

The composition was deposited onto a front surface of a silicon substrate ((average) number of raised portions: 9) by screen printing in a predetermined pattern, followed by drying in an IR drying furnace. A cell formed according to this procedure was subjected to baking at 600°C to 900°C for 60 to 210 seconds in a belt-type baking furnace, thereby fabricating a solar cell.

### Examples 2 to 6 and Comparative Examples 1 to 4

Solar cells were fabricated in the same manner as in Example 1 except that silicon substrates and glass frits listed in Table 1 were used.

**Table 1**

| | Silicon substrate ((average) number of raised portions) | Glass frit |
|---|---|---|
| Example 1 | 9 | Pb-Te-O glass frit (Tg: 241°C, Tc: 410°C, Tm: 485°C) |
| Example 2 | 14 | Te-Ag-O glass frit (Tg: 175°C, Tc: 267°C, Tm: 395°C) |
| Example 3 | 19 | Mo-B-O glass frit (Tg: 445°C, Tc: 505°C, Tm: 668°C) |
| Example 4 | 5 | Pb-Si-O glass frit (Tg: 271°C, Tc: 420°C, Tm: 630°C) |
| Example 5 | 17 | Pb-Te-O glass frit (Tg: 246°C, Tc: 395°C, Tm: 565°C) |
| Example 6 | 23 | Bi-Te-O glass frit (Tg: 296°C, Tc: 419°C, Tm: 611°C) |
| Comparative Example 1 | 11 | Te-Ag-O glass frit (Tg: 146°C, Tc: 327°C, Tm: 441°C) |
| Comparative Example 2 | 16 | Bi-Mo-O glass frit (Tg: 490°C, Tc: 523°C, Tm: 710°C) |
| Comparative Example 3 | 2 | Pb-Te-O glass frit (Tg: 263°C, Tc: 330°C, Tm: 621°C) |
| Comparative Example 4 | 0 | Pb-Te-O glass frit (Tg: 263°C, Tc: 330°C, Tm: 621°C) |

### Property evaluation

(1) Number of raised portions: The number of raised portions having a height (h) of 50 nm or more per 5 µm length was measured ten times using an electron microscope image of the cross section of each of the solar cells fabricated in Examples and Comparative Examples, followed by averaging the values. Results are shown in Table 1.
(2) Serial resistance (Rs, Ω), fill factor (%) and efficiency (%): Each of the compositions for solar cell electrodes prepared in Examples and Comparative Examples was deposited onto a front surface of a wafer by screen printing in a predetermined pattern, followed by drying in an IR drying furnace. Then, an aluminum paste was printed onto a back surface of the wafer and dried in the same manner as above. A cell formed according to this procedure was subjected to baking at 400°C to 900°C for 30 to 180 seconds in a belt-type baking furnace, and then evaluated as to serial resistance (Rs, Ω), fill factor (FF, %) and conversion efficiency (Eff., %) using a solar cell efficiency tester CT-801 (Pasan Co., Ltd.). Results are shown in Table 2.

**Table 2**

| | Serial resistance (Ω) | FF (%) | Eff. (%) |
|---|---|---|---|
| Example 1 | 0.002471 | 78.85 | 18.19 |
| Example 2 | 0.002962 | 78.39 | 18.10 |
| Example 3 | 0.003078 | 78.20 | 18.03 |
| Example 4 | 0.002887 | 78.43 | 18.11 |
| Example 5 | 0.002349 | 78.99 | 18.23 |
| Example 6 | 0.002455 | 78.89 | 18.20 |
| Comparative Example 1 | 0.003465 | 77.56 | 17.74 |
| Comparative Example 2 | 0.003381 | 77.28 | 17.64 |
| Comparative Example 3 | 0.004073 | 77.03 | 17.45 |
| Comparative Example 4 | 0.018874 | 55.89 | 14.18 |

As shown in Table 2, it can be seen that the solar cells of Examples 1 to 6 in which the number of raised portions and the glass transition temperature of the glass frit fell within the ranges set forth herein had excellent serial resistance (Rs) and thus high fill factor (FF) and conversion efficiency (Eff.)

Conversely, the solar cell of Comparative Example 1 in which the glass transition temperature of the glass frit was less than the range set forth herein had high serial resistance (Rs) due to formation of a thick glass layer (i.e, an insulator) between Si and an Ag electrode, and the solar cell of Comparative Example 2 in which the glass transition temperature of the glass frit exceeded the range set forth herein had high serial resistance (Rs) due to poor flowability and thus poor ARC etching performance.

In addition, the solar cells of Comparative Examples 3 to 4 in which the number of raised portions of the silicon substrate was less than the range set forth herein had high serial resistance (Rs) and thus low conversion efficiency (Eff.)

The scope of the present invention should be defined by the appended claims.

### <List of Reference Numerals>

- 10:: substrate
- 11:: semiconductor substrate
- 12:: emitter
- 21:: rear electrode
- 23:: front electrode

## Claims

1. A solar cell (100) comprising:
a silicon substrate (10); and
an electrode (23) formed on the silicon substrate,
wherein the electrode is formed of a composition for solar cell electrodes comprising a conductive powder, an organic vehicle and a glass frit, **characterized in that**
the silicon substrate is formed with at least 5 raised portions having a cross-sectional height (h) of 50 nm or more per 5 µm length, and
the glass frit has a glass transition temperature (Tg) of 150°C to 450°C.

2. The solar cell according to claim 1, wherein the glass frit has a crystallization temperature (Tc) of 300°C to 650°C.

3. The solar cell according to claim 1 or 2, wherein the glass frit has a melting point (Tm) of 350°C to 700°C.

4. The solar cell according to claims 1 to 3, wherein the glass frit is formed of a metal oxide, the metal oxide comprising at least one elemental metal selected from among tellurium (Te), lithium (Li), zinc (Zn), bismuth (Bi), lead (Pb), sodium (Na), phosphorus (P), germanium (Ge), gallium (Ga), cerium (Ce), iron (Fe), silicon (Si), tungsten (W), magnesium (Mg), molybdenum (Mo), cesium (Cs), strontium (Sr), titanium (Ti), tin (Sn), indium (In), vanadium (V), barium (Ba), nickel (Ni), copper (Cu), potassium (K), arsenic (As), cobalt (Co), zirconium (Zr), manganese (Mn), aluminum (Al), and boron (B).

5. The solar cell according to claims 1 to 4, wherein the glass frit comprises at least one selected from among Bi-Te-O glass frits, Pb-Bi-O glass frits, Pb-Te-O glass frits, Te-B-O glass frits, Te-Ag-O glass frits, Pb-Si-O glass frits, Bi-Si-O glass frits, Te-Zn-O glass frits, Bi-B-O glass frits, Pb-B-O glass frits, Bi-Mo-O glass frits, Mo-B-O glass frits, and Te-Si-O glass frits.

6. The solar cell according to claims 1 to 5, wherein the glass frit has an average particle diameter of 0.1 µm to 10 µm.

7. The solar cell according to claims 1 to 6, wherein the composition for solar cell electrodes comprises: 60 wt% to 95 wt% of the conductive powder; 0.1 wt% to 20 wt% of the glass frit; and 1 wt% to 30 wt% of the organic vehicle.

8. The solar cell according to claims 1 to 7, wherein the composition for solar cell electrodes further comprises at least one additive selected from among a dispersant, a thixotropic agent, a plasticizer, a viscosity stabilizer, an anti-foaming agent, a pigment, a UV stabilizer, an antioxidant, and a coupling agent.

## Patentansprüche

1. Solarzelle (100), die Folgendes umfasst:
ein Siliciumsubstrat (10); und
eine auf dem Siliciumsubstrat ausgebildete Elektrode (23),
wobei die Elektrode aus einer Zusammensetzung für Solarzellenelektroden, die ein leitfähiges Pulver, einen organischen Träger und eine Glasfritte umfasst, gebildet wird,
**dadurch gekennzeichnet, dass**,
das Siliciumsubstrat mit wenigstens 5 erhöhten Teilbereichen mit einer Querschnittshöhe (h) von 50 nm oder mehr, bezogen auf eine Länge von 5 µm, gebildet wird und
die Glasfritte eine Glasübergangstemperatur (Tg) von 150 °C bis 450 °C aufweist.

2. Solarzelle nach Anspruch 1, wobei die Glasfritte eine Kristallisationstemperatur (Tc) von 300 °C bis 650 °C aufweist.

3. Solarzelle nach Anspruch 1 oder 2, wobei die Glasfritte einen Schmelzpunkt (Tm) von 350 °C bis 700 °C aufweist.

4. Solarzelle nach den Ansprüchen 1 bis 3, wobei die Glasfritte aus einem Metalloxid gebildet wird, wobei das Metalloxid wenigstens ein aus Tellur (Te), Lithium (Li), Zink (Zn), Wismut (Bi), Blei (Pb), Natrium (Na), Phosphor (P), Germanium (Ge), Gallium (Ga), Cer (Ce), Eisen (Fe), Silizium (Si), Wolfram (W), Magnesium (Mg), Molybdän (Mo), Cäsium (Cs), Strontium (Sr), Titan (Ti), Zinn (Sn), Indium (In), Vanadium (V), Barium (Ba), Nickel (Ni), Kupfer (Cu), Kalium (K), Arsen (As), Cobalt (Co), Zirconium (Zr), Mangan (Mn), Aluminium (Al) und Bor (B) ausgewähltes elementares Metall umfasst.

5. Solarzelle nach den Ansprüchen 1 bis 4, wobei die Glasfritte wenigstens eine umfasst, die aus Bi-Te-O-Glasfritten, Pb-Bi-O-Glasfritten, Pb-Te-O-Glasfritten, Te-B-O-Glasfritten, Te-Ag-O-Glasfritten, Pb-Si-O-Glasfritten, Bi-Si-O-Glasfritten, Te-Zn-O-Glasfritten, Bi-B-O-Glasfritten, Pb-B-O-Glasfritten, Bi-Mo-O-Glasfritten, Mo-B-O-Glasfritten und Te-Si-O-Glasfritten ausgewählt ist.

6. Solarzelle nach den Ansprüchen 1 bis 5, wobei die Glasfritte einen durchschnittlichen Teilchendurchmesser von 0,1 µm bis 10 µm aufweist.

7. Solarzelle nach den Ansprüchen 1 bis 6, wobei die Zusammensetzung für Solarzellenelektroden Folgendes umfasst: 60 Gew.-% bis 95 Gew.-% des leitfähigen Pulvers; 0,1 Gew.-% bis 20 Gew.-% der Glasfritte; und 1 Gew.-% bis 30 Gew.-% des organischen Trägers.

8. Solarzelle nach den Ansprüchen 1 bis 7, wobei die Zusammensetzung für Solarzellenelektroden ferner wenigstens ein Additiv umfasst, das aus einem Dispergiermittel, einem Thixotropiermittel, einem Weichmacher, einem Viskositätsstabilisator, einem Entschäumer, einem Pigment, einem UV-Stabilisator, einem Antioxidans und einem Haftvermittler ausgewählt ist.

## Revendications

1. Cellule solaire (100) comprenant :
un substrat de silicium (10), et
une électrode (23) formée sur le substrat de silicium,
l'électrode étant formée d'une composition pour électrodes de cellules solaires comprenant une poudre conductrice, un véhicule organique et une fritte de verre,
**caractérisée en ce que** le substrat de silicium est formé avec au moins 5 parties surélevées possédant une hauteur de section transversale (h) de 50 nm ou plus par longueur de 5 µm, et la fritte de verre possède une température de transition vitreuse (Tg) de 150 °C à 450 °C.

2. Cellule solaire selon la revendication 1, la fritte de verre possédant une température de cristallisation (Tc) de 300 °C à 650 °C.

3. Cellule solaire selon la revendication 1 ou 2, la fritte de verre possédant un point de fusion (Tm) de 350 °C à 700 °C.

4. Cellule solaire selon les revendications 1 à 3, la fritte de verre étant formée d'un oxyde métallique, l'oxyde métallique comprenant au moins un métal élémentaire choisi parmi le tellure (Te), le lithium (Li), le zinc (Zn), le bismuth (Bi), le plomb (Pb), le sodium (Na), le phosphore (P), le germanium (Ge), le gallium (Ga), le cérium (Ce), le fer (Fe), le silicium (Si), le tungstène (W), le magnésium (Mg), le molybdène (Mo), le césium (Cs), le strontium (Sr), le titane (Ti), l'étain (Sn), l'indium (In), le vanadium (V), le baryum (Ba), le nickel (Ni), le cuivre (Cu), le potassium (K), l'arsenic (As), le cobalt (Co), le zirconium (Zr), le manganèse (Mn), l'aluminium (Al), et le bore (B).

5. Cellule solaire selon les revendications 1 à 4, la fritte de verre comprenant au moins l'un choisi parmi des frittes de verre de type Bi-Te-O, des frittes de verre de type Pb-Bi-O, des frittes de verre de type Pb-Te-O, des frittes de verre de type Te-B-O, des frittes de verre de type Te-Ag-O, des frittes de verre de type Pb-Si-O, des frittes de verre de type Bi-Si-O, des frittes de verre de type Te-Zn-O, des frittes de verre de type Bi-B-O, des frittes de verre de type Pb-B-O, des frittes de verre de type Bi-Mo-O, des frittes de verre de type Mo-B-O, et des frittes de verre de type Te-Si-O.

6. Cellule solaire selon les revendications 1 à 5, la fritte de verre possédant un diamètre moyen de particule de 0,1 µm à 10 µm.

7. Cellule solaire selon les revendications 1 à 6, la composition pour électrodes de cellules solaires comprenant : 60 % en poids à 95 % en poids de la poudre conductrice ; 0,1 % en poids à 20 % en poids de la fritte de verre ; et 1 % en poids à 30 % en poids du véhicule organique.

8. Cellule solaire selon les revendications 1 à 7, la composition pour électrodes de cellules solaires comprenant en outre au moins un additif choisi parmi un dispersant, un agent thixotropique, un plastifiant, un stabilisant de la viscosité, un agent anti-mousse, un pigment, un stabilisant UV, un antioxydant, et un agent de couplage.
